(19) Europäisches Patentamt
European Patent Office
Office européen des brevets

(11) **EP 4 501 886 A1**

(12) **EUROPEAN PATENT APPLICATION**
published in accordance with Art. 153(4) EPC

(43) Date of publication:
**05.02.2025 Bulletin 2025/06**

(21) Application number: **23774806.6**

(22) Date of filing: **17.03.2023**

(51) International Patent Classification (IPC):
*C04B 35/58* [(2006.01)]    *C01B 21/06* [(2006.01)]
*C04B 35/645* [(2006.01)]    *C23C 14/34* [(2006.01)]

(52) Cooperative Patent Classification (CPC):
**C01B 21/06; C04B 35/58; C04B 35/645; C23C 14/34**

(86) International application number:
**PCT/JP2023/010611**

(87) International publication number:
**WO 2023/182211 (28.09.2023 Gazette 2023/39)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **25.03.2022 JP 2022049235**

(71) Applicant: **Tosoh Corporation**
**Yamaguchi 746-8501 (JP)**

(72) Inventors:
• **IIHAMA, Junya**
**Ayase-shi, Kanagawa 252-1123 (JP)**
• **KUSUSE, Yoshiro**
**Ayase-shi, Kanagawa 252-1123 (JP)**
• **HARA, Shinichi**
**Ayase-shi, Kanagawa 252-1123 (JP)**
• **KANO, Erisa**
**Ayase-shi, Kanagawa 252-1123 (JP)**
• **MESUDA, Masami**
**Ayase-shi, Kanagawa 252-1123 (JP)**

(74) Representative: **Müller-Boré & Partner**
**Patentanwälte PartG mbB**
**Friedenheimer Brücke 21**
**80639 München (DE)**

(54) **GALLIUM NITRIDE SINTERED BODY AND PRODUCTION METHOD THEREFOR**

(57) Provided is at least one of a high gallium nitride sintered body that is less subject to increases in oxygen content caused by re-oxidation after sintering than known gallium nitride sintered bodies obtained by the hot pressing process, a method for producing the gallium nitride sintered body, or use of the gallium nitride sintered body. The gallium nitride sintered body comprises a surface layer having a higher density than an inner portion of the sintered body. The atomic mass ratio of gallium to the sum of gallium and nitrogen is more than 0.5 and 0.60 or less.

FIG. 1

EP 4 501 886 A1

**Description**

TECHNICAL FIELD

The present disclosure relates to a gallium nitride sintered body.

BACKGROUND ART

A gallium nitride (GaN) sintered body is used as a sputtering target to stably form a gallium nitride film by sputtering. The gallium nitride sintered body is produced by, for example, the hot isostatic pressing (hereinafter also referred to as "HIP") process. The HIP process, however, leads to high production costs, and it is difficult to produce a large sintered body by the HIP process. On the other hand, the hot pressing (hereinafter also referred to as "HP") process is known as an inexpensive method for producing a gallium nitride sintered body than the HIP process. It is, however, difficult to achieve densification of gallium nitride by the HP process. In addition, the oxygen content of sintered bodies produced by the HP process tends to increase after sintering due to oxidation of remaining metallic gallium and gallium nitride, that is, re-oxidation of the sintered bodies.

There have been thus various studies to achieve further densification of gallium nitride sintered bodies produced by the HP process and to reduce the oxygen content of the gallium nitride sintered bodies (e.g., Patent Documents 1 to 3).

PRIOR ART DOCUMENTS

PATENT DOCUMENTS

Patent Document 1: JP-A 2012-144424
Patent Document 2: JP-A 2017-024970
Patent Document 3: JP-A 2019-001681

DISCLOSURE OF INVENTION

TECHNICAL PROBLEM

In Patent Document 1, gallium oxide is reduced by supplying ammonia gas to a sintered body produced by the HP process to reduce the oxygen content of the sintered body. It is, however, difficult to achieve further densification of the gallium nitride sintered body while reducing gallium oxide because gallium oxide is denser than gallium nitride.

In Patent Documents 2 and 3, a gallium nitride powder with a low oxygen concentration is used as a raw material for gallium nitride. The use of this powder provides a sintered body with a low oxygen content. Patent Documents 2 and 3, however, are directed to improvements in terms of raw materials, and neither solve the problems of the HP process itself nor provide a technique for directly preventing increases in the oxygen content of the sintered body caused by re-oxidation.

An object of the present disclosure is to provide at least one of a gallium nitride sintered body that is less subject to increases in oxygen content caused by re-oxidation after sintering than known gallium nitride sintered bodies obtained by the HP process, a method for producing the gallium nitride sintered body, or use of the gallium nitride sintered body.

SOLUTION TO PROBLEM

The inventors have studied prevention of re-oxidation after sintering and densification of a gallium nitride sintered body obtained by the HP process and have focused on metallic gallium contained in the gallium nitride sintered body. The inventors have further found that the sintered body has high density and is less subject to re-oxidation after sintering when such metallic gallium is nitrided under particular conditions.

That is, the present invention is as described in the claims, and the gist of the present disclosure is as follows.

[1] A gallium nitride sintered body comprising a surface layer having a higher density than an inner portion of the sintered body, wherein an atomic mass ratio of gallium to a sum of gallium and nitrogen is more than 0.5 and 0.60 or less.
[2] The sintered body according to [1], wherein the sintered body has an oxygen content of 0.3 atm% or less.
[3] The sintered body according to [1] or [2], wherein the sintered body has a measured density of 3.80 g/cm$^3$ or more and 5.50 g/cm$^3$ or less.

[4] The sintered body according to any one of [1] to [3], wherein the sintered body contains metallic gallium.

[5] A method for producing the sintered body according to any one of [1] to [4], the method comprising a step of reacting a gallium nitride bulk body with a nitrogen compound-containing gas at a reaction temperature of 1025°C or lower in an atmosphere where the nitrogen compound-containing gas flows at 0.5 L/min or more.

[6] The production method according to [5], wherein the bulk body is a gallium nitride pre-sintered body.

[7] The production method according to [6], wherein the pre-sintered body is a gallium nitride sintered body obtained by a hot pressing process.

[8] The production method according to [5], wherein the bulk body is a gallium nitride green body.

[9] The production method according to any one of [5] to [8], wherein the bulk body contains metallic gallium at least in a surface thereof.

[10] The production method according to any one of [5] to [9], wherein the nitrogen compound-containing gas is at least one gas selected from the group consisting of ammonia, hydrazine and alkylamines.

[11] A sputtering target comprising the sintered body according to any one of [1] to [4].

ADVANTAGEOUS EFFECTS OF INVENTION

The present disclosure can provide at least one of a gallium nitride sintered body that is less subject to increases in oxygen content caused by re-oxidation after sintering than known gallium nitride sintered bodies obtained by the HP process, a method for producing the gallium nitride sintered body, or use of the gallium nitride sintered body.

BRIEF DESCRIPTION OF DRAWINGS

[Fig. 1] An SEM observation image (magnification: 500 times) of a cross-section of a sintered body in Example 4.

[Fig. 2] An SEM observation image (magnification: 500 times) of a cross-section of a sintered body in Comparative Example 1.

DESCRIPTION OF EMBODIMENTS

A sintered body of the present disclosure will be described below by way of exemplary embodiments.

The sintered body of this embodiment is a gallium nitride sintered body comprising a surface layer having a higher density than an inner portion of the sintered body, wherein the atomic mass ratio of gallium to the sum of gallium and nitrogen is more than 0.5 and 0.60 or less.

This embodiment relates to a gallium nitride sintered body. The gallium nitride (GaN) sintered body is a sintered body containing gallium nitride as a main component (matrix, base phase), or a sintered body mainly composed of gallium nitride, that is, a gallium nitride sintered body. The gallium nitride sintered body may contain components, such as metallic gallium, other than gallium nitride, and preferably contains metallic gallium. The sintered body of this embodiment is, for example, a sintered body containing metallic gallium and containing gallium nitride as a main component.

The sintered body of this embodiment may contain a dopant element. The dopant element for n-type semiconductors is, for example, at least one selected from the group consisting of silicon (Si), germanium (Ge), tin (Sn) and lead (Pb). The dopant element for p-type semiconductors is, for example, at least one selected from the group consisting of beryllium (Be), magnesium (Mg), calcium (Ca), strontium (Sr), vanadium (Ba), zinc (Zn) and cadmium (Cd). The dopant element for LEDs producing desired colors is, for example, at least one of aluminum (Al) and indium (In).

The sintered body of this embodiment has a surface layer having a higher density than an inner portion of the sintered body. The surface layer is less subject to oxidation and significantly suppresses re-oxidation of the sintered body.

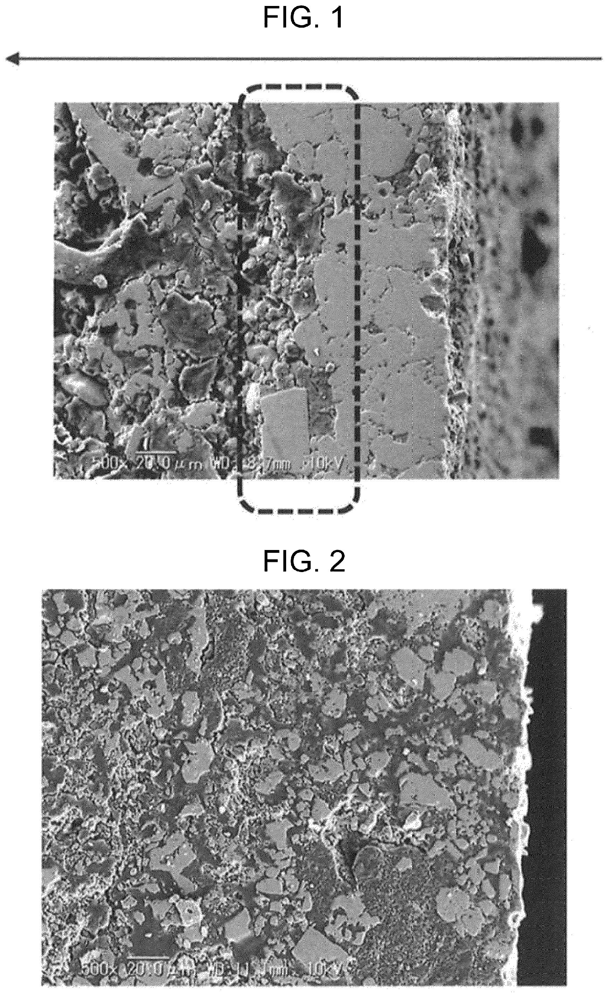

In this embodiment, the surface layer and the inner portion of the sintered body can be observed by scanning electron microscope (hereinafter also referred to as "SEM") observation of a cross-section of the sintered body. In an SEM observation image of a cross-section of a sintered body as shown in Fig. 1, there is a region (dashed line area in Fig. 1; hereinafter also referred to as "transition region") where a dense microstructure changes to a sparse microstructure in the direction from the surface to the opposing surface (the direction of the arrow in Fig. 1; hereinafter also referred to as "thickness direction") such that dense and sparse areas coexist. A sintered body may be determined to have a surface layer when there is a transition region that can be observed in an SEM observation image at an observation magnification of 100 to 500 times. On the other hand, as illustrated in Fig. 2, a sintered body can be determined to have no surface layer when the sintered body has a uniform microstructure in the thickness direction and there is no transition region that can be observed.

In the sintered body of this embodiment, the surface layer has a higher density than the inner portion of the sintered body. The presence of the surface layer can further improve the mechanical properties of the sintered body. The density of the surface layer and the inner portion of the sintered body can be determined from an SEM observation image of a cross-section of the sintered body. More specifically, first, a region of 0% to 1% in the thickness direction (hereinafter also referred to as "surface region") is observed as a surface layer, and a region of 40% to 50% in the thickness direction (hereinafter also referred to as "inner region") is observed as an inner portion of the sintered body with an SEM. Next, the image of each of the surface region and the inner region is analyzed by using common image analysis software (e.g., Image-Pro 10, available from Hakuto Co., Ltd.) to detect voids and the area of the voids. The voids can be detected from a binarized SEM observation image. As a result of image analysis, the area density [%] of each region may be determined using the following formula from the area [$\mu m^2$] of parts excluding voids with respect to the observed area [$\mu m^2$] of the SEM observation image.

Area density [%] = {(area of parts excluding voids)/(observed area of SEM observation image)} $\times$ 100

In the sintered body of this embodiment, the surface layer may have a higher area density than the inner portion of the sintered body. For example, the surface layer has a higher area density than the inner portion of the sintered body, and the difference in area density (= (area density of surface region) - (area density of inner region) is preferably 10% or more, 15% or more, or 20% or more, and is, for example, 30% or less or 25% or less. The upper limit and lower limit of the difference in the area density of the sintered body may be any combination of the above values. The difference in the area density of the sintered body is, for example, 10% or more and 30% or less, or 20% or more and 25% or less.

The density of the inner portion of the sintered body in terms of area density is, for example, less than 90%, 80% or less, 70% or less, 65% or less, 60% or less, or 58% or less, and is, for example, 50% or more or 55% or more. The upper limit and lower limit of the area density of the inner portion of the sintered body may be any combination of the above values. The area density of the inner portion of the sintered body is, for example, 50% or more and less than 90%, 50% or more and 65% or less, or 55% or more and 60% or less.

In this embodiment, the surface layer may have any thickness. The thickness of the surface layer is, for example, 10 $\mu m$ or more, 20 $\mu m$ or more, or 50 $\mu m$ or more, and is, for example, 500 $\mu m$ or less, 300 $\mu m$ or less, 200 $\mu m$ or less, 150 $\mu m$ or less, 120 $\mu m$ or less, 100 $\mu m$ or less, or 80 $\mu m$ or less. The thickness of the surface layer is, for example, 10 $\mu m$ or more and 500 $\mu m$ or less, 10 $\mu m$ or more and 100 $\mu m$ or less, or 20 $\mu m$ or more and 80 $\mu m$ or less. The thickness of the surface layer is measured as the length from the outermost surface to the transition region in an SEM observation image of a cross-section of the sintered body of this embodiment. The thickness of the surface layer may be determined by measuring the thickness at 5 points with regular intervals in the direction perpendicular to the thickness direction in 5 or more fields of view, preferably 10 $\pm$ 2 fields of view, from the SEM observation image and calculating the average thickness.

The bulk density of the sintered body of this embodiment is preferably 3.80 g/cm$^3$ or more and 5.50 g/cm$^3$ or less. The bulk density is preferably 3.80 g/cm$^3$ or more, 4.00 g/cm$^3$ or more, or 4.20 g/cm$^3$ or more. Having such a bulk density, the sintered body of this embodiment tends to have enough strength when used as a sputtering target. A higher bulk density is preferred. The bulk density is, for example, 5.00 g/cm$^3$ or less, 4.80 g/cm$^3$ or less, or 4.70 g/cm$^3$ or less. The upper limit and lower limit of the bulk density of the sintered body may be any combination of the above values. The bulk density of the sintered body is, for example, 3.80 g/cm$^3$ or more and 5.00 g/cm$^3$ or less, or 4.20 g/cm$^3$ or more and 4.70 g/cm$^3$ or less.

The "density" in this embodiment is a bulk density measured by the method in accordance with JIS R 1634, and pretreatment may be performed by a vacuum method using distilled water.

In the sintered body of this embodiment, the atomic mass ratio of gallium to the sum of gallium and nitrogen ([mol/mol]; hereinafter also referred to as "Ga/(Ga + N)") is more than 0.5 and 0.60 or less. When Ga/(Ga + N) is in this range, re-oxidation is suppressed with elution of metallic gallium suppressed. To make the sintered body less subject to re-oxidation, Ga/(Ga + N) is preferably 0.51 or more, 0.52 or more, or 0.53 or more, and is preferably 0.58 or less, 0.57 or less, 0.56 or less, 0.55 or less, or 0.54 or less. The upper limit and lower limit of Ga/(Ga + N) of the sintered body may be any combination of the above values. The sintered body has a Ga/(Ga + N) of, for example, more than 0.5 and 0.58 or less, 0.51 or more and 0.56 or less, 0.52 or more and 0.55 or less, or 0.53 or more and 0.54 or less.

The oxygen content of the sintered body of this embodiment is preferably 0.3 atm% or less, more preferably 0.2 atm% or less, still more preferably 0.1 atm% or less. The sintered body of this embodiment is preferably free of oxygen (i.e., preferably has an oxygen content of 0 atm%), but the oxygen content is, for example, 0 atm% or more, more than 0 atm%, or 0.01 atm% or more. With such an oxygen content, a film obtained by sputtering this sintered body tends to exhibit properties more suitable for light emitting diodes, power devices, or other applications. The upper limit and lower limit of the oxygen content of the sintered body may be any combination of the above values. The oxygen content of the sintered body is, for example, 0 atm% or more and 0.3 atm% or less, 0 atm% or more and 0.2 atm% or less, more than 0 atm% and 0.2 atm% or less, or 0.01 atm% or more and 0.1 atm% or less.

The composition represented by the following formula may be regarded as the composition of the sintered body

of this embodiment.

$$100 = W_{Ga} \text{ [mass\%]} + W_O \text{ [mass\%]}$$
$$+ W_N \text{ [mass\%]} + W_X \text{ [mass\%]} \qquad (1)$$

In formula (1), $W_{Ga}$, $W_O$, $W_N$ and $W_X$ are the mass percentages of gallium, oxygen, nitrogen and a dopant element in the sintered body, respectively. $W_O$ and $W_N$ are values measured by a thermal decomposition method in which the gallium nitride sintered body is thermally decomposed using a common oxygen and nitrogen analyzer (e.g., LECO ON736, available from LECO Corporation), and $W_X$ is a value measured by glow discharge mass spectrometry. $W_{Ga}$ is a value determined using formula (1) from the measured values of $W_O$, $W_N$ and $W_X$.

The oxygen content is a value determined using formula (2) below.

$$\text{The oxygen content [atm\%]}$$
$$= (W_O/M_O)/\{(W_{Ga}/M_{Ga}) + (W_N/M_N)$$
$$+ (W_O/M_O) + (W_X/M_X)\} \qquad (2)$$

In formula (2), $M_O$ is the atomic mass of oxygen: 16.00 [g/mol], $M_{Ga}$ is the gallium content of oxygen: 69.72 [g/mol], and $M_N$ is the atomic mass of nitrogen: 14.01 [g/mol]. $M_X$ is the atomic mass of the dopant element, for example, the atomic mass of silicon: 28.09 [g/mol], the atomic mass of magnesium: 24.31 [g/mol], the atomic mass of aluminum: 26.98 [g/mol], or the atomic mass of indium: 114.82 [g/mol].

Ga/(Ga + N) is a value determined using formula (3) below.

$$\text{Ga/(Ga + N)}$$
$$= (W_{Ga}/M_{Ga})/\{(W_{Ga}/M_{Ga}) + (W_N/M_N)\} \qquad (3)$$

The sintered body of this embodiment can be used in known applications of gallium nitride sintered bodies, and is preferably a sintered body for sputtering targets.

Next, a method for producing the sintered body of this embodiment will be described.

The method for producing the sintered body of this embodiment may be any production method having the above characteristics. A preferred production method includes a step of reacting a gallium nitride bulk body with a nitrogen compound-containing gas at a reaction temperature of 1025°C or lower in an atmosphere where the nitrogen compound-containing gas flows at 0.5 L/min or more. In the related art, there have been studies about the reaction between a gallium nitride sintered body and a nitrogen compound-containing gas. In this embodiment, however, it has been found that the flow rate of the nitrogen compound-containing gas affects the conditions of the reaction between the nitrogen compound-containing gas and the gallium nitride sintered body and that controlling the flow rate of the nitrogen compound-containing gas accelerates the reaction on the surface of the bulk body and easily produces the sintered body of this embodiment. In this embodiment, the bulk body is an object having a certain shape instead of an indefinite shape like powder or liquid. The bulk body is, for example, a sintered body or a green body.

In the step (hereinafter also referred to as "densification step") of reacting the gallium nitride bulk body with the nitrogen compound-containing gas in an atmosphere where the nitrogen compound-containing gas flows at a flow rate of 0.5 L/min or more, metallic gallium present in the surface of the gallium nitride sintered body is efficiently nitrided to form a dense gallium nitride layer (surface layer).

The gallium nitride bulk body (hereinafter also referred to simply as "bulk body") subjected to the densification step is a bulk body consisting essentially of gallium nitride, but preferably contains metallic gallium as a trace component. The bulk body is preferably a gallium nitride bulk body containing metallic gallium, more preferably a gallium nitride bulk body containing metallic gallium at least in the surface thereof.

The bulk body is preferably a gallium nitride pre-sintered body containing metallic gallium, more preferably a gallium nitride pre-sintered body containing metallic gallium at least in the surface thereof. Such a sintered body may be a gallium nitride sintered body produced by any production method, preferably a gallium nitride sintered body produced by the HIP process or the HP process, more preferably a gallium nitride sintered body produced by the HP process. The gallium nitride sintered body produced by the HP process tends to contain metallic gallium in the surface thereof.

The bulk body is preferably a gallium nitride green body containing metallic gallium, more preferably a gallium nitride green body containing metallic gallium at least in the surface thereof. The gallium nitride green body produced by molding tends to contain metallic gallium in the surface thereof.

The bulk body has a Ga/(Ga + N) of, for example, more than 0.50 or 0.55 or more. The bulk body has a Ga/(Ga + N) of, for example, 0.60 or less or 0.58 or less. The upper limit and lower limit of Ga/(Ga + N) of the bulk body may be any combination of the above values. The bulk body has a Ga/(Ga + N) of, for example, more than 0.50 and 0.60 or less, more than 0.50 and 0.58 or less, or 0.55 or more and 0.58 or less.

The bulk body preferably contains metallic gallium at least in the surface thereof. When the surface contains metallic gallium, metallic gallium present in the surface is nitrided so that the density of the surface easily increases in the densification step. In this embodiment, the presence of metallic gallium in the bulk body may be confirmed by the XRD pattern of the bulk body surface having an XRD peak for Ga (metal).

The bulk body is preferably free of gallium oxide. In this embodiment, the phrase "free of gallium oxide" means that the powder X-ray diffraction pattern has no powder X-ray diffraction peak of gallium oxide. The bulk body may contain gallium oxide to such an extent that no powder X-ray diffraction peak of gallium oxide appears in the powder X-ray diffraction pattern. The phrase "no powder X-ray diffraction peak of gallium oxide appears" means that the ratio of the peak intensity of the (002) plane of gallium oxide to the peak intensity of the (002) plane of gallium nitride is less than 1%.

The oxygen content of the bulk body is preferably 0.3 atm% or less, 0.2 atm% or less, or 0.1 atm% or less. With such an oxygen content, pore formation caused by oxygen desorption in the densification step and an increase in surface roughness caused by pore formation are less likely to occur. The oxygen content of the bulk body is preferably low, for example, 0 atm% or more or more than 0 atm%. The upper limit and lower limit of the oxygen content of the bulk body may be any combination of the above values.

The bulk density of the bulk body is preferably 3.50 g/cm$^3$ or more or 4.00 g/cm$^3$ or more. When the bulk body has a bulk density of 3.50 g/cm$^3$ or more, a gallium nitride sintered body having a practical mechanical strength is produced in the densification step. The bulk density is preferably high, for example, 5.00 g/cm$^3$ or less or 4.80 g/cm$^3$ or less. The upper limit and lower limit of the bulk density of the bulk body may be any combination of the above values.

In the densification step, the gallium nitride bulk body is reacted with the nitrogen compound-containing gas at a reaction temperature of 1025°C or lower in an atmosphere where the nitrogen compound-containing gas flows at 0.5 L/min or more. In an atmosphere of nitrogen-containing flow at less than 0.5 L/min, the reaction between metallic gallium and the nitrogen compound-containing gas does not proceed well, and if the reaction proceeds, not enough gallium nitride is formed to increase the density of the surface of the bulk body. The flow rate of the nitrogen compound-containing gas is 0.5 L/min or more, preferably 1.0 L/min or more or 2.0 L/min or more. The flow rate of the nitrogen compound-containing gas does not need to be higher than necessary, and may be 10.0 L/min or less, 8.0 L/min or less, or 7.0 L/min or less. The flow rate of the nitrogen compound-containing gas may be any combination of the above values and is, for example, 0.5 L/min or more and 10.0 L/min or less, 1.0 L/min or more and 8.0 L/min or less, 2.0 L/min or more and 7.0 L/min or less, or 2.0 L/min or more and 4.0 L/min or less.

The "nitrogen compound-containing gas" in this embodiment is a gas containing a compound including a nitrogen atom in its structure, preferably a gas containing a nitrogen-containing compound that reacts with the bulk body. Specific examples of the nitrogen compound-containing gas include at least one gas selected from the group consisting of ammonia, hydrazine and alkylamines. The nitrogen compound-containing gas is, for example, ammonia gas.

In the densification step, the bulk body is reacted with the nitrogen compound-containing gas at a reaction temperature of 1025°C or lower in an atmosphere where the nitrogen compound-containing gas flows. The reaction may be carried out under the conditions where the nitrogen compound-containing gas comes into contact with the bulk body to accelerate nitriding of the bulk body. For example, the reaction is carried out by using at least one selected from the group consisting of a sintering furnace, a tubular furnace and an atmospheric furnace, preferably an atmospheric furnace. The reaction proceeds in an atmosphere where the nitrogen compound-containing gas flows, either in a pressurized atmosphere or in an atmospheric pressure atmosphere, preferably in an atmospheric pressure atmosphere for convenience.

The reaction temperature is 1025°C or lower. If the reaction temperature exceeds 1025°C, the surface of the sintered body is nitrided rapidly in the atmosphere of the densification step in this embodiment, so that surface peeling or other defects occur. As a result, the density decreases, and re-oxidation tends to occur after sintering. The reaction temperature is preferably 1020°C or lower, more preferably 1000°C or lower, still more preferably 990°C or lower. The reaction temperature may be any temperature at which the reaction between the nitrogen compound-containing gas and the bulk body proceeds. The reaction efficiently proceeds at 900°C or higher or 950°C or higher. The upper limit and lower limit of the reaction temperature may be any combination of the above values. The reaction temperature is, for example, 900°C or higher and 1020°C or lower, 900°C or higher and 1000°C or lower, or 950°C or higher and 1000°C or lower.

Any heating rate may be employed to reach the reaction temperature, and the heating rate is, for example, 100°C/h or higher and 400°C/h or lower.

The treatment time (hereinafter also referred to as "holding time") during which the bulk body is treated with the nitrogen compound-containing gas at the reaction temperature may be freely set according to the amount and size of the bulk body subjected to the reaction and the performance of the reactor used in the reaction. The treatment time at the above reaction temperature is, for example, 0.5 hours or longer or 1 hour or longer, and 10 hours or shorter or 5 hours or shorter. The upper limit and lower limit of the treatment time may be any combination of the above values. The treatment time is, for example, 0.5 hours or longer and 10 hours or shorter, or 1 hour or longer and 5 hours or shorter.

The production method of this embodiment may include a step of processing the sintered body (hereinafter also referred to as "processing step") after the densification step.

The processing step is a step of processing the gallium nitride sintered body into a shape suitable for the intended use. For example, when the sintered body of this embodiment is used as a sputtering target, the sintered body may be processed by using at least one processing method selected from the group consisting of surface grinding, rotary grinding and cylindrical grinding. In the processing step, the sintered body may be bonded to a backing plate.

Next, a sputtering target including the sintered body of this embodiment will be described.

A sputtering target including the sintered body of this embodiment (hereinafter also referred to as "target of this embodiment") is a sputtering target in which the sintered body of this embodiment is attached to a support with a bonding layer therebetween.

The target of this embodiment may have any shape and may have at least one of a flat plate shape or a cylindrical shape, or other shapes suitable for the intended use.

In the target of this embodiment, the sintered body of this embodiment is attached (i.e., bonded) to the support with the bonding layer therebetween. The bonding layer may be made of solder containing at least one selected from the group consisting of tin, indium and zinc. To improve the electrical and thermal conductivity of the target, the bonding layer is preferably made of solder containing indium. When the bonding layer is made of solder containing indium, the target of this embodiment may have a wettability improving layer (hereinafter also referred to as "barrier layer") between the gallium nitride sintered body and the bonding layer. The barrier layer improves the indium wettability of the gallium nitride sintered body, which results in a stronger attachment between the gallium nitride sintered body and the bonding layer. The barrier layer may be made of a component with high wettability to indium, preferably at least one of nickel or chromium.

On the other hand, the target of this embodiment preferably has no tungsten (W)-containing layer, more preferably no tungsten-containing layer as a barrier layer, since it increases costs.

The support in the target of this embodiment is preferably made of at least one selected from the group consisting of copper, stainless steel and titanium. The support may have a desired shape according to the shape of the sintered body of this embodiment and may have at least one of a flat plate shape or a cylindrical shape, or other shapes suitable for the intended use.

EXAMPLES

The present disclosure will be described below by way of Examples. However, the present disclosure is not limited to these Examples.

(Composition)

The mass percentages [mass%] of nitrogen and oxygen [mass%] in the gallium nitride sintered body were measured by inert gas fusion-infrared absorption using an oxygen and nitrogen analyzer (device name: LECO ON736, available from LECO Corporation). From the obtained mass percentages of oxygen and nitrogen, the mass percentage of gallium, the oxygen content [atm%] and Ga/(Ga + N) were determined using formula (1), formula (2) and formula (3) above, respectively.

(Bulk Density)

The bulk density of the gallium nitride sintered body was measured by the method in accordance with JIS R 1634. Pretreatment was performed by a vacuum method using distilled water.

(Density)

As the density of the surface layer and the inner portion of the sintered body, the area density of the surface layer and the inner portion of the sintered body was determined from an SEM observation image obtained by SEM observation of a cross-section of the sintered body. More specifically, the sintered body was embedded in resin, and the embedded sintered body was then cut and polished to a surface roughness $Ra \leq 1.0 \mu m$ to expose a cross-section for cross-sectional observation. The cross-section was observed using an SEM (device name: VE-9800, available from KEYENCE Corporation). The conditions of the SEM observation are as described below.

Acceleration voltage: 10 kV
Observation magnification: (surface region) 100 times, (inner region) 500 times

Field of view for observation: 10 fields of view

In the SEM observation image of the cross-section, a region of 0% to 1% from the surface of the sintered body in the thickness direction was regarded as a surface region, and a region of 40% to 50% in the thickness direction was regarded as an inner region. The area density of each of the regions was determined by image analysis of the SEM observation image of each region. Specifically, the SEM observation image of the cross-section was binarized using image analysis software (software name: Image-Pro 10, available from Hakuto Co., Ltd). Voids were detected by distinguishing the voids from the regions (i.e., crystal grains that constitute the sintered body) other than the voids, and the area [$\mu m^2$] of the voids was determined. After detection, the area density [%] of each of the surface region and the inner region was determined using the following formula from the area [$\mu m^2$] of the regions other than the voids with respect to the observed area [$\mu m^2$] of the SEM observation image.

$$\text{Area density} = \text{(area of regions other than voids)} / \text{(observed area of SEM observation image)} \} \times 100$$

SEM observation images of the cross-section in 10 fields of view per sample were each subjected to image analysis, and the average area density was used as the area density of each sample.

(Thickness of Surface Layer)

In an SEM observation image of a cross-section obtained by the same method as for the area density of the surface layer, a region where the density changed in the surface layer was regarded as a transition region, and a region from the surface to the transition region was regarded as a surface layer. The thickness of the surface layer was measured. The measurement was performed in 10 fields of view, and the average thickness was used as the thickness of the surface layer.

(Vickers Hardness)

The Vickers hardness of the sintered body was measured by the method in accordance with JIS Z 2244. The Vickers hardness was measured at 5 points per sample, and the average Vickers hardness was used as the Vickers hardness.

(Measurement of Bending Strength)

The three-point bending strength of the sintered body was measured by the method in accordance with JIS R 1601. The measurement was performed twice, and the average three-point bending strength was used as the bending strength.

Example 1

50 g of gallium nitride powder (purity 4N; 99.99%) was charged into a carbon container having a columnar shape and a diameter of 53 mm. The carbon container was placed in a hot-press machine and heated to 1000°C at a heating rate of 200°C/h, and the hot pressing process was carried out at a process temperature of 1070°C and a process pressure of 40 MPa for 2 hours. After the hot pressing process, the temperature was lowered to about 50°C over 5 hours, and the gallium nitride sintered body was then collected. The gallium nitride sintered body was cut into a gallium nitride sintered body having a disk shape with a diameter of 2 inches (= 5.3 mm) and a thickness of 3.8 mm, which was used as a pre-sintered body. The bulk density of the pre-sintered body was 4.47 g/cm$^3$, and the XRD peak for metallic Ga was observed in the XRD pattern.

The obtained pre-sintered body was placed in an atmospheric furnace (product name: MS-4272, available from MOTOYAMA CO., LTD.) and heated under the following conditions to provide a sintered body of this Example.

Heat treatment atmosphere: ammonia flow atmosphere
(ammonia gas flow rate: 2 L/min)
Heating rate: 200°C/h
Holding temperature: 980°C
Holding time: 1 hour
Cooling rate: 200°C/h

Example 2

A sintered body of this Example was produced by the same method as in Example 1 except that the ammonia gas flow rate was 4 L/min.

Example 3

A sintered body of this Example was produced by the same method as in Example 1 except that the ammonia gas flow rate was 6 L/min.

Example 4

A sintered body of this Example was produced by the same method as in Example 1 except that the holding time at 980°C was 5 hours.

Example 5

A sintered body of this Example was produced by the same method as in Example 1 except that the holding time at 980°C was 10 hours.

Example 6

8 g of a mixed powder of metallic gallium and gallium nitride having a Ga/(Ga + N) ratio of 0.59 was prepared and charged into a 10 mm long × 40 mm wide rectangular die. After being charged, the mixed powder was uniaxially pressed into a green body at a pressure of 100 MPa. The green body was subjected to cold isostatic pressing at a pressure of 300 MPa to form a CIP-processed body. The CIP-processed body (green body) was placed on an alumina setter and sintered in an atmospheric furnace under the following conditions to provide a sintered body of this Example.

Heat treatment atmosphere: ammonia flow atmosphere
(ammonia gas flow rate: 2 L/min)
Heating rate: 200°C/h
Holding temperature: 950°C
Holding time: 5 hours
Cooling rate: 200°C/h

Comparative Example 1

A gallium nitride sintered body produced by the same method as for the pre-sintered body used in Example 1 was used as a sintered body of this Comparative Example.

Comparative Example 2

A sintered body of this Comparative Example was produced by the same method as in Comparative Example 1 except that the holding temperature was 1030°C.

The production conditions of Examples and Comparative Examples are shown in Table 1, and the evaluation results are shown in Table 2.

[Table 1]

| | Treatment Conditions | | |
|---|---|---|---|
| | NH$_3$ Flow Rate [L/min] | Holding Temperature [°C] | Holding Time [h] |
| Example 1 | 2 | 980 | 1 |
| Example 2 | 4 | 980 | 1 |
| Example 3 | 6 | 980 | 1 |
| Example 4 | 2 | 980 | 5 |
| Example 5 | 2 | 980 | 10 |

(continued)

| | Treatment Conditions | | |
| --- | --- | --- | --- |
| | NH$_3$ Flow Rate [L/min] | Holding Temperature [°C] | Holding Time [h] |
| Example 6 | 2 | 950 | 5 |
| Comparative Example 1 | | | |
| Comparative Example 2 | 2 | 1030 | 1 |

[Table 2]

| | Thickness of Surface Layer [μm] | Area Density [%] | | | Ga/(Ga+N) | Oxygen Content [atm%] |
| --- | --- | --- | --- | --- | --- | --- |
| | | Surface Region | Inner Region | Difference in Area Density | | |
| Example 1 | 27.1 | 79.0 | 57.1 | 21.9 | 0.54 | 0.08 |
| Example 2 | 82.7 | - | - | - | 0.56 | 0.15 |
| Example 3 | 67.9 | - | - | - | 0.55 | 0.15 |
| Example 4 | 66.0 | 78.7 | 55.4 | 23.3 | 0.54 | 0.10 |
| Example 5 | 97.1 | - | - | - | 0.54 | 0.12 |
| Example 6 | 42.5 | 82.1 | 61.7 | 20.4 | 0.52 | 0.15 |
| Comparative Example 1 | | 57.3 | 57.3 | 0 | 0.58 | 0.20 |
| Comparative Example 2 | 68.1 | 81.4 | 51.8 | 29.6 | 0.49 | 0.28 |

The above tables indicate that, in Examples, the surface region had a higher area density than the inner region, and the sintered bodies had a surface layer with a higher density than the inner portion of the sintered bodies. On the other hand, in Comparative Example 1 without the densification step, the surface region had the same area density as the inner region, and the sintered body had no surface layer and had a high oxygen content. In Comparative Example 2, the sintered body was produced by processing the same pre-sintered body as in Examples but had a Ga/(Ga + N) of less than 0.5 and a high oxygen content, which indicates that the sintered body was subject to re-oxidation. These results show that the sintered bodies of Examples were less subject to increases in oxygen content.

The densification process increased the bulk density by 0.07 g/cm$^3$ in Example 2, 0.08 g/cm$^3$ in Example 3, and 0.09 g/cm$^3$ in Example 4. This indicates that the densification process in Examples tended to increase the bulk density of the sintered bodies.

Measurement Examples

The Vickers hardness and bending strength of the sintered bodies of Examples and Comparative Examples were measured. The measurement was carried out on each of the sintered bodies (hereinafter also referred to as "unprocessed sintered bodies") and sintered bodies (hereinafter also referred to as "processed sintered bodies") prepared by grinding the unprocessed sintered bodies to remove the surface layer. Since the sintered body of Comparative Example 1 had no surface layer, the bending strength and other properties were measured without the above processing. The results are shown in the table below.

[Table 3]

| | Vickers Hardness [HV] | | Bending Strength [MPa] | |
| --- | --- | --- | --- | --- |
| | Unprocessed Sintered Body | Processed Sintered Body | Unprocessed Sintered Body | Processed Sintered Body |
| Example 1 | 68 | 21 | 52 | 16 |
| Example 4 | 66 | 27 | 40 | 13 |
| Comparative Example 1 | 21 | | 48 | |

(continued)

| | Vickers Hardness [HV] | | Bending Strength [MPa] | |
|---|---|---|---|---|
| | Unprocessed Sintered Body | Processed Sintered Body | Unprocessed Sintered Body | Processed Sintered Body |
| Comparative Example 2 | 37 | 29 | 20 | 12 |

The above table indicates that the sintered bodies of Examples had both a high Vickers hardness and a high bending strength due to the presence of the surface layer. With regard to the sintered body of Comparative Example 2, the unprocessed sintered body had a higher Vickers hardness and a higher bending strength than the processed sintered body, but the increases in Vickers hardness and bending strength were small. This suggests that the surface layer was not formed well in the production method of Comparative Example 2.

The entire contents of the description, claims, drawings and abstract of Japanese Patent Application No. 2022-049235, filed on March 25, 2022, are hereby incorporated by reference as the disclosure of the description of the present disclosure.

**Claims**

1. A gallium nitride sintered body comprising a surface layer having a higher density than an inner portion of the sintered body, wherein an atomic mass ratio of gallium to a sum of gallium and nitrogen is more than 0.5 and 0.60 or less.

2. The sintered body according to claim 1, wherein the sintered body has an oxygen content of 0.3 atm% or less.

3. The sintered body according to claim 1 or 2, wherein the sintered body has a measured density of 3.80 g/cm$^3$ or more and 5.50 g/cm$^3$ or less.

4. The sintered body according to any one of claims 1 to 3, wherein the sintered body contains metallic gallium.

5. A method for producing the sintered body according to any one of claims 1 to 4, the method comprising a step of reacting a gallium nitride bulk body with a nitrogen compound-containing gas at a reaction temperature of 1025°C or lower in an atmosphere where the nitrogen compound-containing gas flows at 0.5 L/min or more.

6. The production method according to claim 5, wherein the bulk body is a gallium nitride pre-sintered body.

7. The production method according to claim 6, wherein the pre-sintered body is a gallium nitride sintered body obtained by a hot pressing process.

8. The production method according to claim 5, wherein the bulk body is a gallium nitride green body.

9. The production method according to any one of claims 5 to 8, wherein the bulk body contains metallic gallium at least in a surface thereof.

10. The production method according to any one of claims 5 to 9, wherein the nitrogen compound-containing gas is at least one gas selected from the group consisting of ammonia, hydrazine and alkylamines.

11. A sputtering target comprising the sintered body according to any one of claims 1 to 4.

# FIG. 1

# FIG. 2

# INTERNATIONAL SEARCH REPORT

| International application No. |
| --- |
| **PCT/JP2023/010611** |

## A. CLASSIFICATION OF SUBJECT MATTER

*C04B 35/58*(2006.01)i; *C01B 21/06*(2006.01)i; *C04B 35/645*(2006.01)i; *C23C 14/34*(2006.01)i
FI:   C04B35/58; C04B35/645; C01B21/06 N; C23C14/34 A

According to International Patent Classification (IPC) or to both national classification and IPC

## B. FIELDS SEARCHED

Minimum documentation searched (classification system followed by classification symbols)

C04B35/58; C01B21/06; C04B35/645; C23C14/34

Documentation searched other than minimum documentation to the extent that such documents are included in the fields searched

Published examined utility model applications of Japan 1922-1996
Published unexamined utility model applications of Japan 1971-2023
Registered utility model specifications of Japan 1996-2023
Published registered utility model applications of Japan 1994-2023

Electronic data base consulted during the international search (name of data base and, where practicable, search terms used)

## C. DOCUMENTS CONSIDERED TO BE RELEVANT

| Category* | Citation of document, with indication, where appropriate, of the relevant passages | Relevant to claim No. |
| --- | --- | --- |
| X | WO 2016/158651 A1 (TOSOH CORP) 06 October 2016 (2016-10-06) paragraphs [0065]-[0066], tables 1, 2, example 3 | 1-4, 11 |
| A | entire text, all drawings | 5-10 |
| X | WO 2012/086661 A1 (TOSOH CORP) 28 June 2012 (2012-06-28) paragraphs [0143]-[0146], table 4, second embodiment comparative example 3 | 1, 3, 4, 11 |
| A | paragraphs [0030]-[0031], [0033], [0036], [0065]-[0067] | 2, 5-10 |
| A | JP 2-228470 A (TOSHIBA CORP) 11 September 1990 (1990-09-11) p. 454, upper left column, lines 9-13, p. 455, upper right column, line 9 to lower left column, line 11, example 1 | 1-11 |
| A | JP 2010-215506 A (CREE INC) 30 September 2010 (2010-09-30) entire text, all drawings | 1-11 |

☐ Further documents are listed in the continuation of Box C.   ☑ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| **25 May 2023** | **06 June 2023** |

| Name and mailing address of the ISA/JP | Authorized officer |
| --- | --- |
| **Japan Patent Office (ISA/JP)** **3-4-3 Kasumigaseki, Chiyoda-ku, Tokyo 100-8915** **Japan** | |
| | Telephone No. |

Form PCT/ISA/210 (second sheet) (January 2015)

**INTERNATIONAL SEARCH REPORT**
Information on patent family members

International application No.

**PCT/JP2023/010611**

| Patent document cited in search report | | | Publication date (day/month/year) | Patent family member(s) | | | Publication date (day/month/year) |
|---|---|---|---|---|---|---|---|
| WO | 2016/158651 | A1 | 06 October 2016 | US | 2018/0072570 | A1 | |
| | | | | paragraphs [0104]-[0105], tables 1, 2, example 3 | | | |
| | | | | EP | 3279367 | A1 | |
| | | | | CN | 107429383 | A | |
| WO | 2012/086661 | A1 | 28 June 2012 | US | 2013/0273346 | A1 | |
| | | | | paragraphs [0032]-[0033], [0035], [0038], [0067]-[0069], [0158]-[0161], table 4, second embodiment comparative example 3 | | | |
| | | | | EP | 2657208 | A1 | |
| | | | | CN | 103270000 | A | |
| JP | 2-228470 | A | 11 September 1990 | (Family: none) | | | |
| JP | 2010-215506 | A | 30 September 2010 | WO | 2005/050709 | A2 | |
| | | | | entire text, all drawings | | | |
| | | | | US | 2005/0103257 | A1 | |
| | | | | EP | 2267190 | A1 | |
| | | | | CN | 1894446 | A | |

Form PCT/ISA/210 (patent family annex) (January 2015)

**Patent documents cited in the description**

- JP 2012144424 A
- JP 2017024970 A
- JP 2019001681 A
- JP 2022049235 A